# EUROPÄISCHE PATENTSCHRIFT

(11) **EP 1 190 369 B1**
(45) Veröffentlichungstag und Bekanntmachung des Hinweises auf die Patenterteilung: **14.04.2004**
(21) Anmeldenummer: 01909654.4
(22) Anmeldetag: 18.01.2001
(51) Int. Cl.: G06K 7/00

(54) **KOMMUNIKATIONSENDGERÄT**
COMMUNICATIONS TERMINAL
TERMINAL DE COMMUNICATION

(30) Priorität: 20.01.2000 DE 10002311
(43) Veröffentlichungstag der Anmeldung: 27.03.2002
(73) Patentinhaber: SkiData AG, 5083 Gartenau (AT)
(72) Erfinder: GRABNER, Wolfgang, 83395 Freilassing (DE)
(74) Vertreter: Berngruber, Otto, Dr. Dipl.-Chem.
(86) Internationale Anmeldenummer: PCT/EP2001/000559
(87) Internationale Veröffentlichungsnummer: WO 2001/054049

(56) Entgegenhaltungen:
- DE-A- 3 922 977
- DE-A- 19 651 719

## Beschreibung

Die Erfindung bezieht sich auf ein Endgerät zur Datenkommunikation mit berührungslos arbeitenden Datenträgern, mit einer Sende/Empfangselektronik mit zwei Schwingkreisen mit wenigstens einem Kondensator und einer gemeinsamen Antenne zum Abstrahlen von elektromagnetischen Wellen.

Die Datenträger sind dabei als Transponder ausgebildet. Nach Aktivierung durch das elektromagnetische Feld des Endgerätes können die im Datenträger gespeicherten Daten ausgelesen und gegebenenfalls auch verändert werden.

Berührungslos arbeitende Datenträger, beispielsweise berührungslos arbeitende Chipkarten, werden für die verschiedensten Anwendungen eingesetzt, beispielsweise bei der Benutzung öffentlicher Transportsysteme, als elektronische Geldbörse, Krankenversicherungsausweis und dergleichen. Da die Zahl der Chipkarten, die eine Person mit sich führt, im allgemeinen ständig zunimmt, ist ein Multifunktionsdatenträger anzustreben, der für möglichst viele Anwendungen einsetzbar ist.

Höherfrequente Transponder sind dabei Transpondern mit niedrigerer Trägerfrequenz, insbesondere hinsichtlich der Datenübertragungsgeschwindigkeit, überlegen. Andererseits führen hochfrequente Transponder bei hoher Datenübertragungsgeschwindigkeit zu einer großen Frequenzbandbreite. Es ist daher wünschenswert, je nach Anwendung wahlweise eine hohe oder eine niedrige Trägerfrequenz zur Kommunikation zwischen dem Endgerät und den Datenträgern einsetzen zu können.

Während man früher die Trägerfrequenz weitgehend frei wählen konnte, sind die Trägerfrequenz, die zulässige Frequenzbandbreite und die vom Endgerät abgestrahlte Sendenergie nunmehr durch einschlägige Bestimmungen festgelegt worden. So ist z.B. nach der ISO-Norm eine Trägerfrequenz von 13,56 MHz vorgeschrieben.

Auf der anderen Seite existieren nach wie vor zahlreiche Datenträger, die mit einer anderen, meist deutlich niedrigeren Trägerfrequenz arbeiten. Beispielsweise werden zur Zugangsberechtigung zu Skiliftanlagen, z.B. in eine Armbanduhr, die Kleidung oder dergleichen integrierte Datenträger mit einer Trägerfrequenz von 120-125 kHz verwendet. Ergibt die Kommunikation zwischen Endgerät bzw. Zutrittsterminal und Datenträger eine Zutrittsberechtigung, gibt das Zutrittsterminal ein Freigabesignal ab, beispielsweise zum Freischalten einer Sperrvorrichtung, wie eines Drehkreuzes.

Damit die Endgeräte mit Datenträgern unterschiedlicher Trägerfrequenz kommunizieren können, also z.B. sowohl mit 13,56 MHz-Datenträgern wie mit 125 kHz-Datenträgern, weist nach dem Stand der Technik jedes Endgerät zwei Schwingkreise auf, und zwar einen Schwingkreis mit kleiner Antenne für die niedrige Trägerfrequenz und einen Schwingkreis mit großer Antenne für die hohe Trägerfrequenz ( DE 198 31 767). Dies ist mit einem hohen zusätzlichen Kostenaufwand sowie Platzproblemen verbunden. Zudem können sich die Antennen gegenseitig beeinflussen.

Aus DE 196 51 719 A1 ist ein drahtloses Sende-Empfangs-System beispielsweise zur Abfrage von IC-Karten bekannt, das eine primäre und eine sekundäre Schaltungseinrichtung und somit ein Endgerät zur Kommunikation mit berührungslos arbeitenden Datenträgern aufweist. Die sekundäre Einrichtung umfaßt zwei Schwingkreise, die unterschiedliche Resonanzfrequenzen aufweisen. Die auszusendenden elektromagnetischen Schwingungen werden dabei über die jeweilige Schwingkreisspule abgestrahlt.

Nach WO 94/03982 A1 werden zwei Frequenzen zum Identifizieren verwendet. Aus DE 39 22 977 C2 ist ein Endgerät nach dem Oberbegriff des Anspruchs 1 bekannt, bei dem über die einzige Antenne elektromagnetische Schwingungen unterschiedlicher Frequenzlage abgestrahlt werden, wobei der einzige Schwingkreis durch Zu- oder Abschalten einzelner Kapazitäten in seiner Frequenzlage eingestellt wird.

Aufgabe der Erfindung ist es, den Kostenaufwand und den Platzbedarf für ein Endgerät wesentlich herabzusetzen, das mit Datenträgern mit zwei unterschiedlichen Datenübertragungsträgerfrequenzen zur gleichen Zeit berührungslos kommunizieren kann.

Dies wird erfindungsgemäß durch das im Anspruch 1 gekennzeichnete Endgerät erreicht. In den Unteransprüchen sind vorteilhafte Ausgestaltungen des erfindungsgemäßen Endgerätes wiedergegeben.

Nach der Erfindung wird für beide Schwingkreise, also sowohl für den hochfrequenten wie für den niedrigfrequenten Schwingkreis des Endgerätes eine einzige, gemeinsame Antenne verwendet. Damit wird der Kostenaufwand und der Platzbedarf spürbar verringert. Vorteilhaft ist ferner, daß eine gegenseitige Beeinflussung mehrerer Antennen nicht mehr stattfindet.

Dabei ist erfindungsgemäß in dem Schwingkreis für die niedrige Trägerfrequenz zwischen dessen Kondensator und der Antenne eine Koppel-Induktivitätsspule vorgesehen. Diese Spule bildet für die hohe Trägerfrequenz einen hochohmigen, für die niedrige Trägerfrequenz jedoch nur einen geringen Wechselstromwiderstand, wodurch nur der Schwingkreis für die hohe Trägerfrequenz mit Datenträgern kommuniziert, die auf die hohe Trägerfrequenz ausgelegt sind.

Dabei entspricht das Verhältnis des Wechselstromwiderstandes dieser Spule genau dem Trägerfrequenzverhältnis der beiden Schwingkreise (X_{L} = 2π·f·L). D.h., der Widerstand der Spule ist z.B. bei einer hohen Trägerfrequenz von 13,56 MHz gegenüber einer niedrigen Trägerfrequenz von 125 kHz um das etwa 110-fache größer. Im allgemeinen sollte das Verhältnis der hohen Trägerfrequenz zur niedrigen Trägerfrequenz mindestens 10, vorzugsweise mindestens 50 betragen.

Um sicherzustellen, daß nur der Schwingkreis für die niedrige Trägerfrequenz mit Datenträgern kommuniziert, die auf die niedrige Trägerfrequenz ausgelegt sind, ist vorzugsweise zwischen der Sende/Empfangselektronik des Endgerätes und dem Schwingkreis für die hohe Trägerfrequenz wenigstens ein Kondensator vorgesehen. Dieser Kondensator bildet zusammen mit dem Kondensator im Schwingkreis für die hohe Trägerfrequenz einen hochohmigen Widerstand für die niedrige Trägerfrequenz, für die hohe Trägerfrequenz hingegen einen geringen Widerstand, wodurch nur der Schwingkreis für die niedrige Trägerfrequenz mit Datenträgern kommuniziert, die auf die niedrige Trägerfrequenz ausgelegt sind.

Zugleich bildet der Kondensator (C2) zwischen der Sende/Empfangselektronik und dem Schwingkreis für die hohe Trägerfrequenz gemeinsam mit dem Schwingkreiskondensator (C1) eine Anpasschaltung an die Treiberstufe, wodurch Reflexionen und parasitäre Leistungsabstrahlungen vermieden werden. Die Sende/Empfangselektronik des Endgerätes wird mit einem Koaxialkabel mit entsprechendem Wellenwiderstand mit der Antenne verbunden.

Vorzugsweise weist der Schwingkreis für die hohe Trägerfrequenz wenigstens einen Parallelwiderstand auf, um die Güte dieses Schwingkreises einstellen zu können.

Nach der Erfindung können die beiden Schwingkreise beispielsweise mit einem Multiplexer abwechselnd zur Kommunikation aktiv geschaltet werden. Es ist sogar auch möglich, beide Schwingkreise gleichzeitig zur Kommunikation aktiv zu schalten.

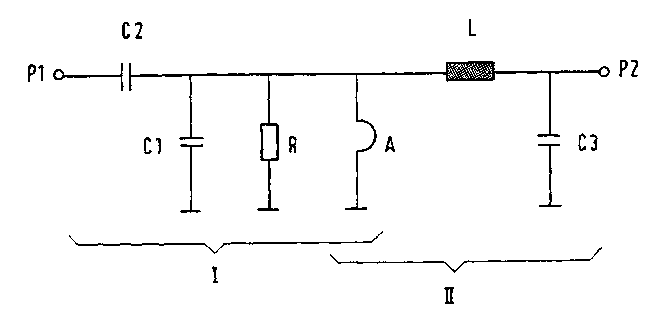

Nachstehend ist die Erfindung anhand der beigefügten Zeichnung beispielhaft näher erläutert, die eine Prinzipschaltung der beiden Schwingkreise zeigt.

Danach umfaßt der Schwingkreis I des (nicht dargestellten) Endgeräts für die hohe Trägerfrequenz von z.B. 13,56 MHz eine Antenne A und einen Kondensator C1. Die (nicht dargestellte) Sende/Empfangselektronik des Endgeräts ist bei P1 angeschlossen, also über einen Kondensator C2 mit dem Schwingkreis I verbunden. Weiterhin weist der Schwingkreis I einen Parallelwiderstand R auf, mit dem die Güte des Schwingkreises bestimmt wird.

Der zweite Schwingkreis II für die niedrige Trägerfrequenz von z.B. 125 kHz umfaßt ebenfalls die Antenne A und den Kondensator C3. Die Antenne A ist damit beiden Schwingkreisen I und II gemeinsam.

Der Schwingkreis II umfaßt ferner eine Induktivitätsspule L zwischen dem Kondensator C3 und der Antenne A. Die Sende/Empfangselektronik ist an den Schwingkreis II bei P2 angeschlossen. Die hohe bzw. niedrige Trägerfrequenz von beispielsweise 13,56 MHz bzw. 125 kHz wird durch entsprechende Sinusoszillatoren in die Schwingkreise I und II eingespeist.

## Patentansprüche

1. Endgerät zur Kommunikation mit berührungslos arbeitenden Datenträgern, mit einer Sende/Empfangselektronik mit zwei Schwingkreisen (I und II) mit wenigstens einem Kondensator (C1, C2) und einer gemeinsamen Antenne (A) zum Abstrahlen von elektromagnetischen Wellen, **dadurch gekennzeichnet, dass** ein Schwingkreis (II) für eine niedrige Trägerfrequenz und der andere Schwingkreis (I) für eine hohe Trägerfrequenz ausgelegt ist, die Sende/Empfangselektronik an den Schwingkreis (I) für die hohe Trägerfrequenz über wenigstens einen Kondensator (C2) angeschlossen ist und in dem Schwingkreis (II) für die niedrige Trägerfrequenz zwischen dem Kondensator (C3) und der Antenne (A) eine Koppel-Induktivitätsspule (L) vorgesehen ist.

2. Endgerät nach Anspruch 1, **dadurch gekennzeichnet, daß** der Schwingkreis (I) für die hohe Trägerfrequenz wenigstens einen Parallelwiderstand (R) aufweist, mit dem die Güte des Schwingkreises eingestellt wird.

3. Endgerät nach einem der vorstehenden Ansprüche, **dadurch gekennzeichnet, daß** das Verhältnis der hohen Trägerfrequenz zur niedrigen Trägerfrequenz wenigstens 10:1 beträgt.

4. Endgerät nach einem der vorstehenden Ansprüche, **dadurch gekennzeichnet, daß** beide Schwingkreise (I und II) abwechselnd zur Kommunikation aktiv geschaltet sind.

5. Endgerät nach einem der Ansprüche 1 bis 3, **dadurch gekennzeichnet, daß** beide Schwingkreise (I und II) gleichzeitig zur Kommunikation aktiv geschaltet sind.

## Claims

1. A terminal device for communication with contactless-type data carriers, having a transceiver electronics with two resonant circuits (I and II) with at least one capacitor (C1, C2) and a common antenna (A) for radiating electromagnetic waves, **characterized in that** one resonant circuit (II) is provided for a low carrier frequency and the other resonant circuit (I) for a high carrier frequency, the transceiver electronics being connected to the resonant circuit (I) for the high carrier frequency by at least one capacitor (C2) and a coupling inductance coil (L) being provided between the capacitor (C3) and the antenna (A) in the resonant circuit (II) for the low carrier frequency.

2. A terminal device according to claim 1, **characterized in that** the resonant circuit (I) for high carrier frequency has at least one shunt resistor (R) for adjusting the quality of the resonant circuit.

3. A terminal device according to any of the above claims, **characterized in that** the ratio of high carrier frequency to low carrier frequency is at least 10:1.

4. A terminal device according to any of the above claims, **characterized in that** both resonant circuits (I and II) are activated for communication alternatingly.

5. A terminal device according to any of claims 1 to 4, **characterized in that** both resonant circuits (I and II) are activated for communication simultaneously.

## Revendications

1. Equipement terminal de communication avec supports de données fonctionnant sans contact avec une électronique d'émission/réception avec deux circuits oscillants (I et II) avec au moins un condensateur (C1, C2) et une antenne commune (A) pour le rayonnement d'ondes électromagnétiques, **caractérisé en ce qu'**un circuit oscillant (II) est paramétré pour une fréquence nominale basse et l'autre circuit oscillant (I) est paramétré pour une fréquence nominale élevée, l'électronique d'émission/réception est raccordée au circuit oscillant (I) pour la fréquence nominale élevée par l'intermédiaire d'au moins un condensateur (C2) et dans le circuit oscillant (II) pour la fréquence nominale basse une bobine de couplage à inductance (L) est prévue entre le condensateur (C3) et l'antenne' (A).

2. Equipement terminal selon la revendication 1, **caractérisé en ce que** le circuit oscillant (I) pour la fréquence nominale élevée comporte au. moins. une résistance parallèle (R) avec laquelle est mise au point la qualité du circuit oscillant.

3. Equipement terminal selon l'une des revendications précédentes, **caractérisé en ce que** le rapport entre la fréquence nominale élevée et la fréquence nominale basse s'élève au moins à 10:1.

4. Equipement terminal selon l'une des revendications précédentes, **caractérisé en ce que** les deux circuits oscillants (I et II) sont commutés activement à tour de rôle pour la communication.

5. Equipement terminal selon l'une des revendications 1 à 3, **caractérisé en ce que** les deux circuits oscillants (I et II) sont commutés activement simultanément pour la communication.
